# EUROPEAN PATENT APPLICATION

(11) **EP 2 023 658 A2**
(43) Date of publication of application: **11.02.2009**
(21) Application number: 08014088.2
(22) Date of filing: 06.08.2008
(51) Int. Cl.: H04R 19/00

(54) **Semiconductor device, lead frame, and microphone package therefor**

(30) Priority: 08.08.2007 JP 2007206724
(71) Applicant: YAMAHA CORPORATION, Naka-ku Hamamatsu-shi Shizuoka-ken (JP)
(72) Inventor: Shirasaka, Kenichi, Hamamatsu-shi Shizuoka-ken (JP)
(74) Representative: Wagner, Karl H.

(57) **Abstract**

A semiconductor device is constituted of a mold sheet for mounting a sensor chip and a cover having a box-like shape, both of which are combined together so as to form a cavity therebetween. The mold sheet includes a stage having a rectangular shape in a plan view, a plurality of cutouts formed in the periphery of the stage, and a plurality of lead terminals arranged inside of the cutouts. The lead terminals include a plurality of connection portions electrically connected to the sensor chip and a plurality of support leads which are externally extended from the periphery of the stage. The stage and the lead terminals are sealed with a mold resin, by which they are electrically insulated from each other. The recesses of the support leads are sealed with the insulating resin mold relative to the surface of the mold sheet so as to mount the opening end of the cover.

## Description

### BACKGROUND OF THE INVENTION

### Field of the Invention

The present invention relates to semiconductor devices having sensor chips and lead frames, which are encapsulated in microphone packages.

The application claims priority on Japanese Patent Application No. 2007-206724, the content of which is incorporated herein by reference.

### Description of the Related Art

In conventionally-known semiconductor devices, sensor chips (for sensing sounds and the like) are incorporated into the hollow cavities defined by substrates and covers and are mounted on the surfaces of substrates. Various types of semiconductor devices have been disclosed in various documents such as Patent Document 1.

Patent Document 1: Japanese Unexamined Patent Application Publication No. 2007-66967

Patent Document 1 teaches a semiconductor device having a substrate which includes a rectangular stage for mounting a sensor chip thereon, a plurality of leads arranged in the surrounding area of the stage, and a resin layer, which is molded so as to seal the stage and the leads. Herein, the stage for mounting a sensor chip is partially exposed from the resin layer, and the distal ends of the leads electrically connected to the sensor chip via wires are exposed externally of the resin layer, wherein an opening of a cover is formed in the resin layer surrounding the surface of the stage.

Since the stage and the cover have conductive property, it is possible to shield electromagnetic noise from entering in to the hollow cavity by means of the stage and the cover. This avoids erroneous operation of the sensor chip due to electromagnetic noise.

The aforementioned semiconductor device suffers from a gap between the periphery of the stage and the cover and gaps between the leads adjoining together, wherein these gaps are not completely covered with the stage and the cover. Hence, it is likely that electromagnetic noise may enter into the cavity via the gaps.

### SUMMARY OF THE INVENTION

It is an object of the present invention to provide a semiconductor device, which is designed to reduce gaps allowing electromagnetic noise to enter into a cavity by use of resin mold technology, thus achieving shield performance substantially equivalent to that of a ceramic package.

It is another object of the present invention to provide a lead frame for use in the semiconductor device.

It is a further object of the present invention to provide a microphone package adapted to the semiconductor device.

In a first aspect of the present invention, a semiconductor device includes a sensor chip, a mold sheet having a rectangular shape in a plan view and including a stage having a conductive property, in which a plurality of cutouts is formed in the periphery thereof, a plurality of lead terminals each having a conductive property which is arranged inside of the plurality of cutouts and is electrically connected to the sensor chip, and a resin mold having an insulating property which is formed to electrically insulate the stage from the plurality of lead terminals, and a cover having an opening and a box-like shape, which is combined with the mold sheet so as to form a cavity therebetween. The sensor chip is mounted on the surface of the stage which forms the same plane as the surface of the mold sheet. The lead terminals include connection portions having internal connection surfaces, which are exposed in the cavity and are electrically connected to the sensor chip, and support leads which are elongated from the connection portions towards the stage so that the distal ends thereof are exposed on the side surface of the mold sheet. In the prescribed portions of the support leads positioned in the cutouts, the recesses are formed and recessed in width directions thereof and are sealed with the mold resin. The opening end of the cover is fixed onto the mold sheet above the recesses of the support leads sealed with the resin mold.

In the above, the sensor chip is electrically connected to the internal connection surfaces of the lead terminals, which are exposed in the cavity, via wires. The recesses of the lead terminals are sealed with the resin mold and are not exposed on the surface of the mold sheet; hence, the lead terminals are electrically insulated from the cover.

The opening end of the cover is brought into contact with the surface of the mold sheet so that the stage is electrically connected to the cover. When the semiconductor device is mounted on a substrate (or a circuit board) having a ground pattern, the stage and the cover are electrically connected to the ground pattern so as to form a shield structure for blocking electromagnetic noise from entering into the cavity. The shield structure entirely covers the cavity except for the cutouts of the stage that are not brought into contact with the cover; hence, it is possible to minimize gaps allowing electromagnetic noise from entering into the cavity.

In a second aspect of the present invention, a lead frame, which is produced using a thin metal plate, includes a stage having a rectangular shape in a plan view for mounting a sensor chip thereon, a plurality of lead terminals which are electrically connected to the sensor chip and which have a plurality of connection portions integrally connected with the stage, a plurality of cutouts which are formed in the periphery of the stage so as to arrange the lead terminals and the connection portions therein, and a plurality of support leads which are externally elongated from the connection portions. A plurality of recesses is formed on the support leads inside of the cutouts.

The mold sheet for use in the semiconductor device can be easily produced using the aforementioned lead frame. Specifically, the stage and the lead terminals are clamped by a metal mold in the thickness direction; then, a melted resin composed of an insulating material is injected into a cavity formed between the recesses of the support leads of the lead terminals and the interior surface of the metal mold so as to form the resin mold for sealing the stage and the lead terminals. Herein, the recesses are sealed with the resin mold while the surface of the stage is exposed from the resin mold, wherein the surface of the stage forms the same plane as the surface of the mold sheet. When the opening end of the cover is mounted on the recesses sealed with the resin mold, it is possible to prevent the lead terminals from coming into contact with the cover.

In this connection, the stage and the lead terminals are integrally formed using the lead frame produced using the thin metal plate, wherein the recesses are formed by partially etching the surface of the thin metal plate substantially corresponding to the surface of the stage, and wherein the stage is formed by partially etching the backside of the thin metal plate and is thus reduced in thickness so that the lower side of the stage is sealed with the resin mold. In the lead frame, the recesses are formed by partially etching the surface of the thin metal plate, and the stage is formed by partially etching the backside of the thin metal plate.

In the mold sheet forming step, even when the stage and the lead terminals are clamped by the metal mold in the thickness direction, it is possible to prevent the stage and the lead terminals from being deformed; thus, it is possible to easily produce the semiconductor device. When the lead terminals are subjected to press working or bending while the stage is upset so that the recesses are positioned lower than the surface of the stage, the connection portions and bent portions of the lead terminals may be easily deformed during clamping of the lead frame by the metal mold so that the stage and the lead terminals may be partially distanced from the interior surface of the metal mold, whereby resin burrs may be formed in boundaries between the stage, the lead terminals, and the metal mold. In contrast, the present invention is designed such that the stage and the recesses are formed via etching; hence, it is possible to prevent the stage and the lead terminals from being deformed during the formation of the resin mold; thus, it is possible to easily avoid the formation of resin burrs.

In this connection, the thickness of the resin mold (for sealing the stage and the lead terminals) is substantially identical to the original thickness of the thin metal plate prior to etching; hence, it is possible to reduce the overall thickness of the semiconductor device.

Alternatively, the connection portions of the lead terminals can be formed by etching the backside of the thin metal plate so that the lower sides of the connection portions are sealed with the resin mold. In this case, the lead terminals are clamped in the thickness direction by the metal mold; hence, it is possible to improve the engagement between the lead terminals and the resin mold; in other words, it is possible to prevent the lead terminals from being unexpectedly separated from the resin mold.

The mold sheet has a ground terminal (having a conductive property) which is formed integrally with the stage so as to project from the backside of the stage and which is electrically connected to the sensor chip. The external connection surface of the ground terminal is exposed from the resin mold below the stage. The aforementioned shield structure can be formed by simply bringing the ground terminal in contact with the ground pattern of the substrate. That is, the stage engages with the resin mold via the ground terminal. In other words, it is possible to improve the engagement between the stage and the resin mold due to the anchor effect of the ground terminal; hence, it is possible to prevent the stage from being separated from the resin mold.

The sensor chip is a microphone chip having a sound detector for detecting pressure variations, for example. A sound hole allowing the cavity to communicate with the external space can be formed to run through the cover. The sound hole allows pressure variations (e.g. variations of sound pressures) to enter into the cavity and to reach the sound detector, which thus detect pressure variations.

In a third aspect of the present invention, a microphone package includes a microphone chip, a mold sheet having a rectangular shape in a plan view and including a stage having a conductive property, in which a plurality of cutouts is formed in the periphery thereof, a plurality of lead terminals each having a conductive property which is arranged inside of the cutouts and is electrically connected to the microphone chip, and a resin mold having an insulating property which is formed to electrically insulate the stage from the lead terminals, and a cover having a box-like shape, which is combined with the mold sheet so as to form a housing including a cavity and a sound hole. The lead terminals are arranged inside of the cutouts and are thus electrically insulated from the stage via the resin mold. The lead terminals include a ground terminal formed integrally with the stage and a plurality of internal connection surfaces electrically connected to the microphone chip. The stage and the lead terminals are sealed with the resin mold such that the surface of the stage and the internal connection surfaces are exposed from the mold sheet in the housing. The cover is electrically insulated from the lead terminals and is electrically connected to the stage.

In the above, the microphone chip is electrically connected to the internal connection surfaces of the lead terminals, which are exposed in the housing, via wires. By electrically connecting the external connection surface of the ground terminal to the ground pattern of the substrate (for mounting the microphone package), it is possible to form the shield structure (for blocking electromagnetic noise from entering into the cavity) by means of the cover and the stage. The shield structure entirely covers the cavity except for the cutouts of the stage which do not come in contact with the lead terminals; hence, it is possible to minimize gaps allowing electromagnetic noise from entering into the cavity.

In the microphone package, the mold sheet includes a lead frame, which is produced using a thin metal plate, wherein the lead terminals have support leads which are externally extended from the periphery of the stage so that the distal ends thereof are exposed on the side surface of the mold sheet. The support leads have recesses, which are sealed with the insulating resin mold relative to the surface of the mold sheet so as to mount the opening end of the cover.

The lead frame is equipped with a frame so that the support leads extended from the lead terminals join the frame. The recesses are formed by performing half-etching on the support leads. The stage is interconnected with a plurality of interconnection leads which are externally extended from the periphery of the stage so that the distal ends thereof are exposed on the side surface of the mold sheet. The lead frame is sealed with the resin mold such that the recesses of the support leads are sealed with the resin mold. The mold sheet is subjected to cutting so as to cut out the interconnection leads.

In the mold sheet forming step, it is possible to prevent the stage and the lead terminals from being deformed during the formation of the resin mold by claming the lead frame in the thickness direction; hence, it is possible to easily produce the microphone package.

The interconnection leads are externally extended from the periphery of the stage so that the distal ends thereof are exposed on the side surface of the mold sheet in the microphone package, wherein they are brought into contact with the cover when the cover is fixed onto the mold sheet. Herein, the cover can be directly and electrically connected to the stage.

As described above, the present invention can minimize the gaps allowing electromagnetic noise from entering into the cavity; hence, it is possible to further improve the shield effect of the semiconductor device and the microphone package.

### BRIEF DESCRIPTION OF THE DRAWINGS

These and other objects, aspects, and embodiments of the present invention will be described in more detail with reference to the following drawings.
FIG. 1 is a plan view of a semiconductor device in view of the surface of a resin mold in accordance with a preferred embodiment of the present invention.
FIG. 2 is a plan view of the semiconductor device in view of the backside of the resin mold.
FIG. 3 is a longitudinal sectional view taken along line A-A in FIGS. 1 and 2.
FIG. 4 is a plan view showing a lead frame for use in the semiconductor device in view of the surface of a thin metal plate.
FIG. 5 is a plan view showing the lead frame in view of the backside of the thin metal plate.
FIG. 6 is a plan view showing the lead frame sealed with a resin mold in view of the surface of the thin metal plate.
FIG. 7 is a plan view showing the lead frame sealed with the resin mold in view of the backside of the thin metal plate.
FIG. 8 is a cross-sectional view taken along line B-B in FIGS. 6 and 7.
FIG. 9 is an enlarged cross-sectional view showing essential parts of the semiconductor device which is partially modified.
FIG. 10 is a longitudinal sectional view showing the semiconductor device which is further modified.

### DESCRIPTION OF THE PREFERRED EMBODIMENT

The present invention will be described in further detail by way of examples with reference to the accompanying drawings.

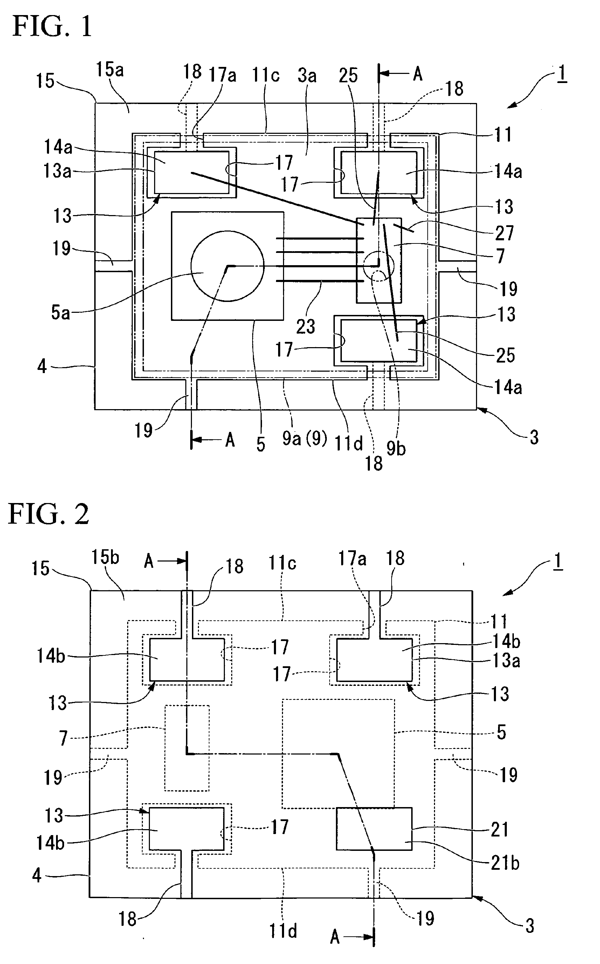

A semiconductor device 1 according to a preferred embodiment of the present invention will be described with reference to FIGS. 1 to 8. The semiconductor device 1 is designed to detect variations of pressures such as sound pressures generated in the external space and is a surface mount type produced using a lead frame.

As shown in FIGS. 1 to 3, the semiconductor device 1 is constituted using a mold sheet 3 having a rectangular shape in a plan view, a microphone chip (or a sensor chip) 5 and a companion chip 7 formed on a surface 3a of the mold sheet 3, and a cover 9 which is arranged above the mold sheet 3 so as to cover the microphone chip 5 and the companion chip 7.

The mold sheet 3 is constituted of a stage 11 which has a rectangular shape in a plan view so as to form the surface 3a of the mold sheet 3, a plurality of lead terminals (e.g. three lead terminals serving as conductive portions) 13, and a resin mold (or an insulating portion) 15 for molding the stage 11 and the lead terminals 13. Both the stage 11 and the lead terminals 13 having conductive properties are formed using a lead frame which is composed of a thin metal plate.

The surface 3a of the mold sheet 3 corresponding to the surface of the stage 11 is exposed externally of a surface 15a of the resin mold 15. A backside 11b of the stage 11 is sealed with the resin mold 15. In the present embodiment, the surface of the stage 11 and the surface 15a of the resin mold 15 form the same plane, i.e. the surface 3a of the mold sheet 3 for mounting the microphone chip 5 and the companion chip 7 thereon.

A plurality of cutouts (e.g. three cutouts) 17 are formed to cut into the stage 11 from its peripheral end. The lead terminals 13 are partially arranged inside of the cutouts 17. Each of the cutouts 17 are increased in area inside of the stage so that an opening 17a thereof is narrower than the bottom of the cutout 17 in width dimensions. In the present embodiment, two of the three cutouts 17 are aligned along a first side 11c of the stage 11, while the remaining one cutout 17 is arranged along a second side 11d (which is opposite to the first side 11c) of the stage 11 and is positioned opposite to one of the two cutouts 17 aligned along the first side 11c of the stage 11.

A plurality of interconnection leads (e.g. three interconnection leads) 19 are extended from the peripheral end of the stage 11 towards a side surface 4 of the resin mold 15. Together with the surface 3a of the stage 11, the interconnection leads 19 are exposed externally of the surface 15a of the resin mold 15.

In the present embodiment, one interconnection lead 19 is formed along the second side 11d of the stage 11 in such a way that it is aligned together with one cutout 17 along the second side 11d and is positioned opposite to the other of the two cutouts 17 aligned along the first side 11c of the stage 11. The other two interconnection leads 19 are formed along the respective sides of the stage 11 which are perpendicular to the first side 11c and the second side 11d, wherein they are positioned opposite to each other.

A ground terminal 21 that projects from the backside 11b of the stage 11 is integrally formed together with the stage 11. The distal end of the ground terminal 21 is exposed externally of the resin mold 15. Specifically, an external connection surface 21b of the ground terminal 21 forms the same plane with a backside 15b of the resin mold 15 substantially matching the backside of the mold sheet 3. When the semiconductor device 1 is mounted on a substrate (or a circuit board, not shown), the ground terminal 21 is electrically connected to a ground pattern (or an external wire, not shown) via solder.

Each of the lead terminals 13 arranged inside of the cutouts 17 of the stage 11 is constituted of a connection portion 13a (having an internal connection surface 14a electrically connected to the companion chip 7) and a support lead 18 (having a plate-like shape elongated externally from the stage 11), so that each of them is not placed in contact with the stage 11. The support lead 18 is arranged in the opening 17a of the cutout 17 so as to project externally from the peripheral portion of the stage 11, wherein the distal end of the support lead 18 is exposed on the side surface 4 of the resin mold 15. The support lead 18 is narrower than the connection portion 13a in width dimensions.

The lead terminals 13 have external connection surfaces 14b, which are exposed externally of the resin mold 15 and are electrically connected to external wires (not shown). The external connection surfaces 14b of the lead terminals 13 form the same plane together with the backside 15b of the resin mold 15. In the present embodiment, the external connection surface 14b entirely covers the backside of the connection portion 13a and the backside of the support lead 18.

As described above, the lead terminals 13 are formed to integrally combine the internal connection surfaces 14a and the external connection surfaces 14b. When the semiconductor device 1 is mounted on a substrate (or a circuit board, not shown), the lead terminals 13 serve as external connection terminals for electrically connecting the microphone chip 5 and the companion chip 7 to connection terminals (or external wires) of the substrate via solder.

All the stage 11, the support leads 18, and the interconnection leads 19 are formed by way of half-etching applied to the foregoing thin metal plate; hence, they have very thin portions that are thinner than the mold sheet 3.

The support leads 18 of the lead terminals 13 are formed by etching the surface of the thin metal plate (forming the surface 3a of the stage 11 and the internal connection surfaces 14a of the connection portions 13a); hence, they have approximately half of the original thickness of the thin metal plate. For this reason, the support leads 18 are positioned lower than the surface 3a of the stage 11. That is, the support leads 18 form a recess 24 which is recessed from the surface of the mold sheet 3 for mounting the cover 9.

The stage 11 and the interconnection leads 19 are formed by etching the backside of the thin metal plate, wherein the thickness of the corresponding portions is reduced approximately a half the original thickness of the thin metal plate. In the stage 11, the ground terminal 21 is not subjected to the foregoing half etching, so that the thickness thereof is identical to the original thickness of the thin metal plate. That is, the thickness of the ground terminal 21 is identical to the thickness of the prescribed parts of the resin mold 15 formed inside of the cutouts 17. The connection portions 13a of the lead terminals 13 are not subjected to half etching, so that the thickness thereof is identical to the original thickness of the thin metal plate.

The resin mold 15 is composed of an electrically insulating material, wherein it is formed to cover the backside 11b of the stage 11, the lower surfaces of the interconnection leads 19, and the recesses 24 of the support leads 18. In addition, the resin mold 15 is also formed to seal the gaps between the stage 11 and the lead terminals 13 arranged inside of the cutouts 17. The surface 3a of the stage 11 and the internal connection surfaces 14a of the lead terminals 13 are exposed externally of the surface 15a of the resin mold 15. The external connection surfaces 14b of the lead terminals 13 and the external connection surface 21 b of the ground terminal 21 are exposed externally of the backside 15b of the resin mold 15.

As described above, the thickness of the prescribed portions of the resin mold 15 sealing the gaps between the stage 11 and the lead terminals 13 arranged inside of the cutouts 17 is substantially identical to the thickness of the thin metal plate prior to foregoing half-etching, whereby the thickness of the mold sheet 3 is substantially identical to the thickness of the thin metal plate.

The cover 9 composed of a conductive material such as copper is formed in a box-like shape having a bottom. The cover 9 is arranged to cover the resin mold 15 formed on the surface 3a of the stage 11 and the recesses 24 of the support leads 18. Herein, an opening end 9a of the cover 9 (which is integrally formed together with the center portion of the cover 9 having the sound hole 9b) is placed on the periphery of the surface 3a of the stage 11 and the prescribed portions of the resin mold 15 formed inside of the openings 17a of the cutouts 17. The opening end 9a of the cover 9 is bonded and fixed onto the surface 3a of the stage 11 via a conductive bonding material 32. This makes it possible to electrically connect the stage 11 to the cover 9.

The support leads 18 arranged in the openings 17a of the cutouts 17 are sealed with the resin mold 15 which forms the same plane as the surface 3a of the stage 11 and are thus not exposed from the surface 3a of the stage 11; hence, the lead terminals 13 are electrically insulated from the cover 9.

By arranging the cover 9 on the mold sheet 3, the hollow cavity S 1 incorporating the microphone chip 5 and the companion chip 7 is defined between the cover 9 and the mold sheet 3. That is, the cover 9 is combined together with the mold sheet 3 so as to form a housing having the hollow cavity S 1.

The surface 3a of the stage 11 and the internal connection surfaces 14a of the connection portions 13a of the lead terminals 13 are exposed inside of the cavity S1 from the resin mold 15. That is, the internal connection surfaces 14a electrically insulated from the stage 11 are exposed inside of the housing. The sound hole 9b allowing the cavity S 1 to communicate with the external space is formed at the prescribed position of the cover 9.

The microphone chip 5 is basically composed of silicon and converts pressure variations such as variations of sound pressures into electric signals, wherein it has s sound detector 5a that vibrates in response to pressure variations. The microphone chip 5 translates vibrations of the sound detector 5 as variations of electric resistance; hence, it produces electric signals based on variations of resistance or variations of capacitance.

The microphone chip 5 is bonded and fixed onto the stage 11 via an insulating bonding paste (not shown) in such a way that the sound detector 5a is positioned opposite to the surface 3a of the stage 11. That is, a cavity S2 is formed between the sound detector 5a of the microphone chip 5 and the surface 3a of the stage 11.

The companion chip 7 drives and controls the microphone chip 5, wherein it includes an amplifier for amplifying electric signals output from the microphone chip 5, an A/D converter for converting electric signals into digital signals, and a digital signal processor (DSP). Similar to the microphone chip 5, the companion chip 7 is fixed onto the surface 3 a of the stage 11 via an insulating bonding paste (not shown).

The companion chip 7 is electrically connected to the microphone chip 5 via first wires (or internal wires) 23 and is electrically connected to the internal connection surfaces 14a of the lead terminals 13 via second wires (or internal wires) 25. In addition, the companion chip 7 is electrically connected to the surface 3a of the stage 11 via a third wire 27. Thus, the microphone chip 5 is electrically connected to the stage 11 and the lead terminals 13 by way of the companion chip 7.

When pressure variations (e.g. variations of sound pressures) enter into the cavity S1 via the sound hole 9b of the cover 9, they reach the sound detector 5a of the microphone chip 5. That is, the semiconductor device 1 forms a microphone package for detecting pressure variations.

Next, a manufacturing method of the semiconductor device 1 will be described in detail.

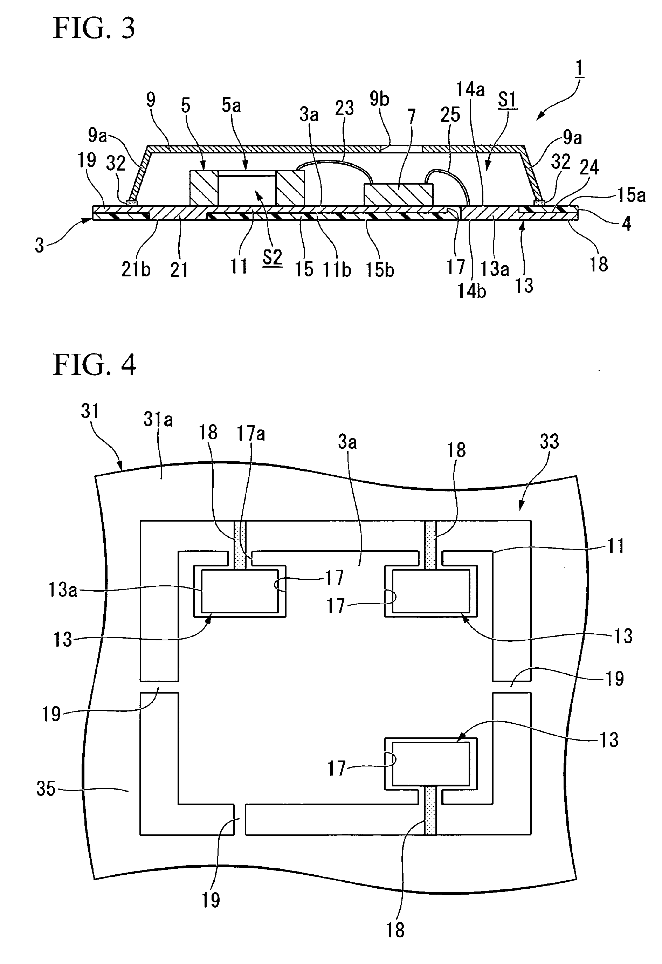

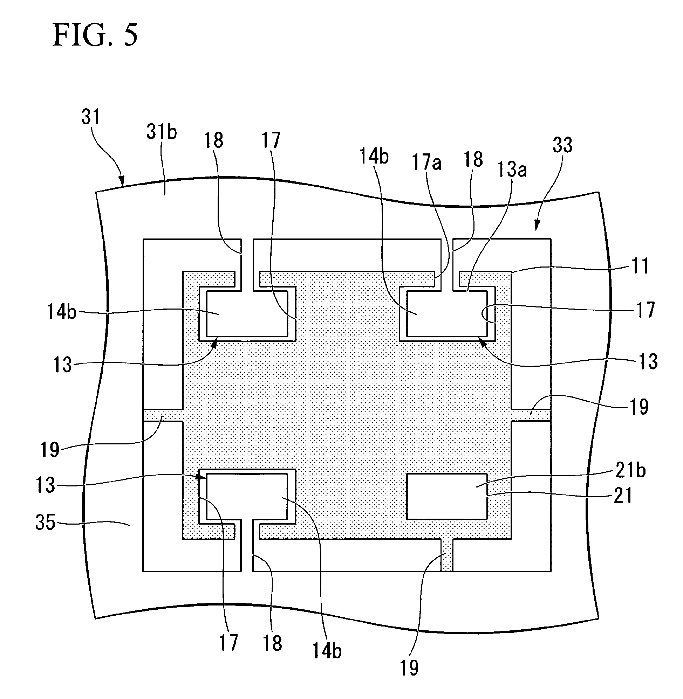

In the manufacturing of the semiconductor device 1, a mold sheet producing step is firstly performed so as to produce the mold sheet 3. In the mold sheet producing step, as shown in FIGS. 4 and 5, the thin metal plate 31 composed of copper is subjected to press working and/or etching so as to perform a lead frame forming step, in which the lead frame 33 is formed in such a way that the lead terminals 13 and the interconnection leads 19 project inwardly of the frame 35, and the interconnection leads 19 are integrally connected with the stage 11 having a rectangular shape in a plan view (which is arranged inside of the frame 35). In the lead frame 33, the frame 35 and the interconnection leads 19 serve as interconnection means for integrally interconnecting the stage 11 and the lead terminals 13.

In the lead frame forming step, the cutouts 17 are formed in the stage 11 such that they are cut into from the periphery of the surface 3a of the stage 11 (corresponding to the surface 31a of the thin metal plate 31), wherein they are positioned such that the connection portions 13a of the lead terminals 13 do not come in contact with the stage 11, and the support leads 18 do not partially come in contact with the stage 11. That is, a plurality of cutouts 17 is formed in the stage 11 having a rectangular shape in a plan view such that they are cut into from the periphery of the stage 11. In addition, the lead terminals 13 are arranged inside of the cutouts 17 with prescribed distances therebetween so as to allow the stage 11 to be molded with a resin while being electrically insulated from the internal connection surfaces 14a and the external connection surfaces 14b.

Next, a half-etching step is performed such that the support leads 18 of the lead terminals 13, the stage 11, and the interconnection leads 19 are subjected to half etching. In this step, half-etching is performed on the surface 31 a of the thin metal plate 31 so as to entirely reduce the thickness of the support leads 18 (see hatched areas in FIG. 4) to be smaller than the original thickness of the thin metal plate 31. This forms the recesses 24 of the support leads 18, which are recessed from the prescribed surface for mounting the opening end 9a of the cover 9.

In this step, half-etching is performed on the backside 31b of the thin metal plate 31, so that a relatively large part of the thin metal plate 31 including the stage 11 and the interconnection leads 19 (see hatched area shown in FIG. 5) except for the ground terminal 21 is reduced in thickness compared with the original thickness of the thin metal plate 31.

This half-etching step can be performed simultaneously with the lead frame forming step; alternatively, it can be performed before or after the lead frame forming step. The lead frame 33 can be formed using a single sheet of the thin metal plate 31; alternatively, it can be formed using multiple sheets laminated together.

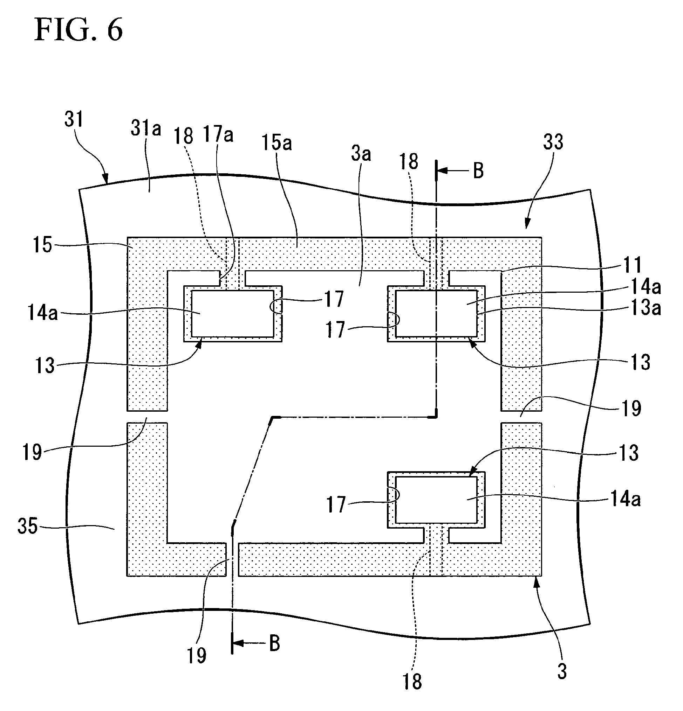

After completion of the lead frame forming step and the half-etching step, the lead frame 33 is molded with the resin mold 15 as shown in FIGS. 6 to 8. In this molding step, the lead frame 33 is clamped in the thickness direction by means of a metal mold (not shown) used for the formation of the resin mold 15, wherein a cavity is formed between the thinned portion of the lead frame 33 (whose thickness is reduced compared with the original thickness of the thin metal plate 31 in the half-etching step) and the interior surface of the metal mold. A melted resin (composed of an insulating material) is injected into the cavity of the metal mold, thus forming the resin mold 15.

Thereafter, the lead terminals 13 and the interconnection leads 19 (which are molded with the resin mold 15) are subjected to cutting and are thus separated from the frame 35 (which is positioned outside of the resin mold 15). This cutting step ends the production of the mold sheet 3. Separation is achieved by cutting the prescribed portion of the resin mold 15 positioned between the stage 11 and the frame 35, whereby the distal ends of the support leads 18 and the distal ends of the interconnection leads 19 are exposed on the cut surface.

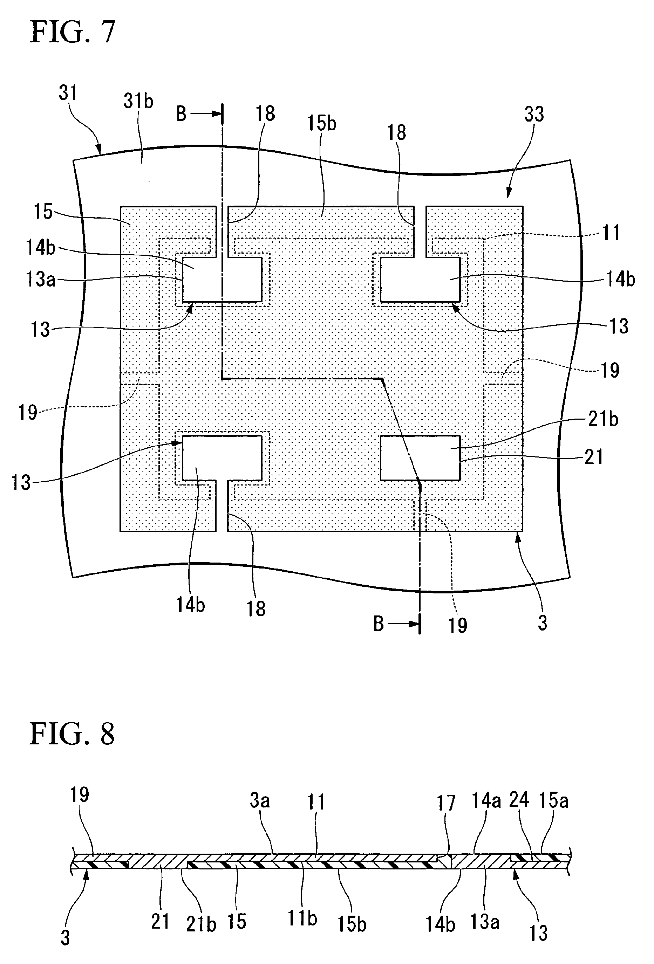

Hatched areas shown in FIG. 6 indicate the resin mold 15 (which is formed in the molding step) in view of the surface 3a of the stage 11. As shown in FIGS. 6 and 8, the surface 3a of the stage 11, the internal connection surfaces 14a of the connection portions 13a of the lead terminals 13, and the interconnection leads 19 are exposed from the resin mold 15 in the same plane as the surface 15a of the resin mold 15. Gaps between the stage 11 and the frame 35 and gaps between connection portions 13a (arranged inside of the cutouts 17 of the stage 11) and the support leads 18 are also filled with the resin. In addition, the upper portions of the support leads 18 are covered with the resin mold 15.

The hatched area shown in FIG. 7 indicates the resin mold 15 (which is formed in the molding step) in view of the backside of the stage 11. As shown in FIGS. 7 and 8, the external connection surfaces 14b of the lead terminals 13 and the external connection surface 21 b of the ground terminal 21 are exposed from the resin mold 15 in the same plane as the backside 15b of the resin mold 15. In addition, the backside 11b of the stage 11 and the lower portions of the interconnection leads 19 are covered with the resin mold 15.

In this mold sheet forming step, the mold sheet 3 is formed with the same thickness as the original thickness of the thin metal plate 31.

After completion of the mold sheet forming step, a chip mounting step is performed as shown in FIGS. 1 to 3 such that the microphone chip 5 and the companion chip 7 are fixed onto the stage 11 (forming the surface 3 a of the mold sheet 3) via an insulating bonding paste (not shown). Next, an electric connection step is performed such that the microphone chip 5 is electrically connected to the companion chip 7 via the first wires 23 by way of wire bonding, the companion chip 7 is electrically connected to the internal connection surfaces 14a of the lead terminals 13 via the second wires 25, and the companion chip 7 is electrically connected to the surface 3 a of the stage 11 via the third wire 27.

Lastly, the cover 9 is fixed onto the periphery of the surface 3a of the stage 11 such that the microphone chip 5 and the companion chip 7 are completely covered with the cover 9. This cover fixing step completes the production of the semiconductor device 1.

In the cover fixing step, the cover 9 is fixed onto the mold sheet 3 via the conductive bonding material 32. Due to the cover fixing step, the opening end 9a of the cover 9 is arranged across the openings 17a of the cutouts 17 in the width direction, whereas the recesses 24 of the support leads 18 are positioned lower than the surface 3a of the stage 11. The recesses 24 of the support leads 18 are sealed with the prescribed portions of the resin mold 15; hence, it is possible to prevent the lead terminals 13 from easily coming in contact with the cover 9.

The manufacturing method of the semiconductor device 1 can be partially modified such that the cutting step of the mold sheet forming step is performed in the prescribed time period between the chip mounting step and the cover fixing step.

When the semiconductor device 1 (which is manufactured in accordance with the aforementioned manufacturing method) is mounted on a substrate (or a circuit board, not shown), the backside 15b of the resin mold 15 is positioned opposite to the surface of the substrate, then, the lead terminals 13 and the ground terminal 21 are electrically connected to lands of the substrate via solder.

Thus, the cover 9 and the stage 11 are electrically connected to the ground pattern of the substrate, thus forming a shield structure for blocking electromagnetic noise from entering into the cavity S1 defined by the cover 9 and the stage 11. The shield structure entirely covers the cavity S 1 except for the cutouts 17 (in which the cover 9 does not come in contact with the stage 11) and the sound hole 9b of the cover 9; hence, it is possible to minimize gaps allowing electromagnetic noise to enter into the cavity S1. The semiconductor device 1 having the lead frame 33 according to the present embodiment can improve the shield performance.

In the semiconductor device 1 having the lead frame 33, the stage 11, half-etching is performed on the interconnection leads 19, and the support leads 18 of the lead terminals 13, so that no bent portion is formed in the lead terminals 13 and the like. This reliably prevent the stage 11 and the lead terminals 13 from being unexpectedly deformed in the molding step in which the lead frame 33 is clamped in the thickness direction by the metal mold. This simplifies the production of the semiconductor device 1.

By way of press working, it may be possible to bend the lead terminals 13 and the interconnection leads 19; then, the stage 11 is upset so that the lead terminals 13 except for the connection portions 13a are positioned lower than the surface 3a of the stage 11. However, in the molding step in which the stage 11 and the lead terminals 13 are clamped by the metal mold, the bent portions of the lead terminals 13 and the bent portions of the interconnection leads 19 are deformed so that the stage 11 and the lead terminals 13 may be partially distanced from the interior wall of the metal mold. In this case, resin burrs may be formed in boundaries between the stage 11 and the interconnection leads 19 and in boundaries between the lead terminals 13 and the resin mold 15.

In contrast, the present embodiment is characterized in that the stage 11 and the lead terminals 13 except for the connection portions 13a are reduced in thickness compared with the original thickness of the thin metal plate 31. This prevents the stage 11 and the lead terminals 13 from being unexpectedly deformed in the molding step; hence, it is possible to easily avoid the formation of resin burrs.

Since the thickness of the resin mold 15 for molding the stage 11 and the lead terminals 13 is substantially identical to the original thickness of the thin metal plate 31, it is possible to easily reduce the overall thickness of the semiconductor device 1.

Since the prescribed part of the resin mold 15 is formed in the surrounding area of the ground terminal 21 (which projects from the backside 11b of the stage 11), the stage 11 engages with the resin mold 15 via the ground terminal 21. This improves the engagement between the stage 11 and the resin mold 15; hence, it is possible to prevent the stage 11 from being unexpectedly separated from the resin mold 15.

It is possible to introduce another method for improving the engagement between the stage 11 and the resin mold 15. For example, a through-hole is formed at a prescribed position of the stage 11 in the thickness direction in the prescribed area except for the regions for mounting the microphone chip 5 and the companion chip 7 and is sealed with the resin mold 15. The resin formed in the through-hole provides an anchor effect, by which the engagement between the stage 11 and the resin mold 15 can be further improved. It is preferable that the through-hole be formed at a prescribed position of the stage 11 which does not degrade the shield performance of the semiconductor device 1.

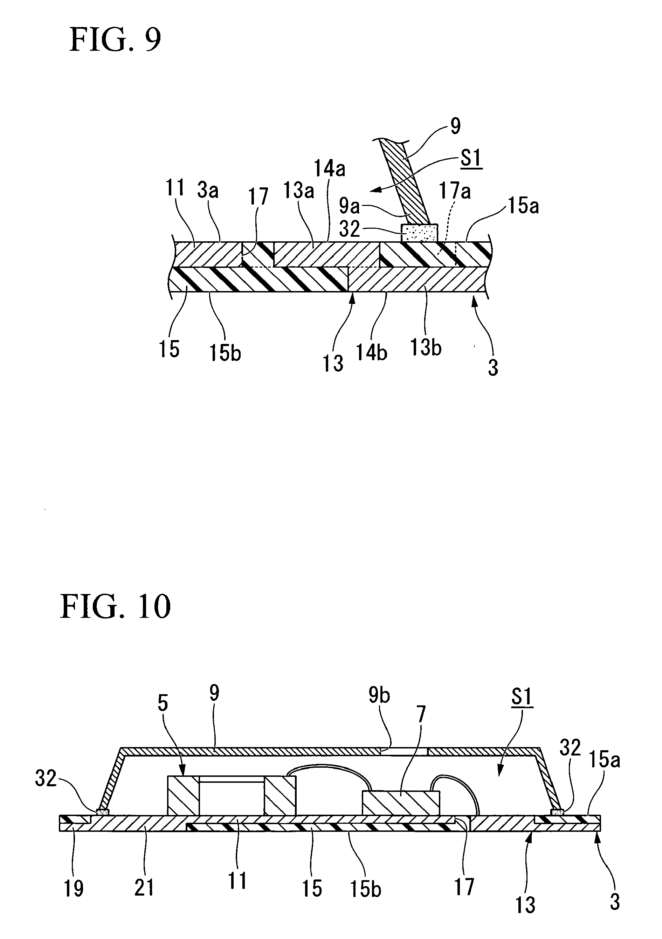

In the present embodiment, the connection portions 13a of the lead terminals 13 have a thickness substantially identical to the original thickness of the thin metal plate 31 prior to etching; but this is not a restriction. For example, as shown in FIG. 9, the connection portions 13a of the lead terminals 13 are reduced in thickness to approximately half of the original thickness of the thin metal plate 31 such that the connection portions 13a are recessed from the external connection surfaces 14b. That is, it is possible to form recessed steps, which are recessed from the backside 15b of the mold sheet 3, in the surrounding areas of the external connection surfaces 14b of the lead terminals 13. In this case, the lower sides of the connection portions 13a are additionally sealed with the resin mold 15 while the recesses 24 of the support leads 18 (which are formed integrally with the connection portions 13a) are sealed with the resin mold 15; hence, the lead terminals 13 are vertically held in the thickness direction by the resin mold 15. This further improves the engagement between the lead terminals 13 and the resin mold 15; hence, it is possible to easily prevent the lead terminals 13 from being unexpectedly separated from the resin mold 15.

In the present embodiment, the interconnection leads 19 (which are integrally formed together with the stage 11) are exposed externally of the surface 15a of the resin mold 15; but this is not a restriction. For example, it is possible to partially modify the semiconductor device 1 as shown in FIG. 10 such that the interconnection leads 19 are not exposed externally of the surface 15a of the resin mold 15 but are exposed externally of the backside 15b of the resin mold 15. That is, similar to the support leads 18, the interconnection leads 19 are processed by performing half-etching on the surface of the thin metal plate 31. In other words, the surfaces of the interconnection leads 19 are recessed from the surface 3a of the mold sheet 3 for mounting the opening end 9a of the cover 9.

In this case, the upper sides of the interconnection leads 19 and the lower side of the stage 11 are sealed with the resin mold 15; in other words, the stage 11 and the interconnection leads 19 (both of which are integrally formed together) are vertically held by the resin mold 15 in the thickness direction. Thus, it is possible to further improve the engagement between the stage 11 and the resin mold 15.

In the case above, similar to the support leads 18 which project outside of the periphery of the stage 11, the interconnection leads 19 interconnected with the frame 35 are exposed from the backside 15b of the resin mold 15 in the lead frame 33; hence, it is possible to easily and rapidly divide the mold sheet 3 into individual pieces by way of press working. In short, it is possible to improve the manufacturing efficiency with regard to semiconductor devices.

In this connection, the interconnection leads 19 can be formed to partially overlap with the ground terminal 21 as shown in FIG. 10.

In the present embodiment, the lead terminals 13 are aligned along the first side 11c and the second side 11d of the stage 11 having a rectangular shape in a plan view; but this is not a restriction. For example, the semiconductor device 1 can be modified such that the lead terminals 13 are aligned along only the first side 11c of the stage 11. In this case, no lead terminal 13 is formed along the other three sides of the stage 11. This eliminates the necessity of forming the cutouts 17 arranging the lead terminals 13; hence, no gap is formed due to the cutouts 17 between the stage 11 and the cover 9 along the other three sides of the stage 11. This reliably blocks electromagnetic noise from entering into the cavity S 1 via the other three sides of the stage 11.

In the above, it is preferable that a plurality of ground terminals (similar to the ground terminal 21 that projects from the backside 11b of the stage 11) is aligned in proximity to and along the second side 11d of the stage 11. Due to the aforementioned alignment of multiple ground terminals, it is possible to mount the semiconductor device 1 on the substrate in a stable manner.

In the present embodiment, both the microphone chip 5 and the companion chip 7 are fixed onto the surface 3a of the stage 11 via the insulating bonding paste; but this is not a restriction. The present embodiment simply requires that they are mounted on the surface 3a of the stage 11. That is, the semiconductor device 1 is partially modified such that the microphone chip 5 and the companion chip 7 are fixed onto the surface of a base mold (composed of a resin) which is additionally formed on the surface 3 a of the stage 11.

The base mold can be formed simultaneously with the resin mold 15 in the mold sheet forming step. Herein, it is necessary that the base mold be formed at a prescribed position evading certain region of the surface 3a of the stage 11 vertically overlapping the opening end 9a of the cover 9.

In the present embodiment, the opening end 9a of the cover 9 is arranged on the periphery of the surface 3a of the stage 11; but this is not a restriction. The present embodiment simply requires the opening end 9a of the cover 9 to be arranged on the surface 3a of the stage 11 such that the microphone chip 5, the companion chip 7, and the internal connection surfaces 14a of the lead terminals 13 are embraced in the cavity S 1. In other words, the opening end 9a of the cover 9 must be electrically connected to a part of the stage 11 such that it is electrically insulated from the lead terminals 13. Furthermore, the opening end 9a of the cover 9 can be arranged on the internal area of the stage 11 positioned inwardly of its periphery except for the prescribed regions for arranging the internal connection surfaces 14a of the lead terminals 13, the microphone chip 5, and the companion chip 7.

In addition, the opening end 9a of the cover 9 can be brought into contact with the interconnection leads 19 and connected to the surface 3a of the stage 11. Alternatively, the opening end 9a of the cover 9 can be brought into contact with the interconnection leads 19 and electrically connected to the surface 3a of the stage 11 via a conductive member which is arranged between the opening end 9a of the cover 9 and the surface 3 a of the stage 11.

The aforementioned modifications increase the overall contact area between the cover 9 and the stage 11; hence, it is possible to establish a reliable fixation between the cover 9 and the stage 11.

In the present embodiment, the cover 9 is fixed onto the surface 3a of the mold sheet 3 via the conductive bonding material 32; but this is not a restriction. Alternatively, the cover can be fixed onto the surface 3a of the mold sheet 3 via solder. In this case, it is possible to fix the cover 9 onto the mold sheet 3 for mounting the microphone chip 5 and the companion chip 7 while soldering mold sheet 3 (electrically connected to the microphone chip 5 and the companion chip 7) to the substrate in the reflow process.

In the present embodiment, the recesses 24 are formed in the entirely lengths of the support leads 18; however, the recesses 24 can be formed in only the prescribed parts of the support leads 18 as long as the cover 9 does not come in contact with the support leads 18. In other words, the recesses 24 can be formed in width directions of the support leads 18 positioned in the openings 17a of the cutouts 17 as long as the cover 9 is fixed onto the mold sheet 3 as described in the present embodiment.

The support leads 18 do not necessarily partially project outside of the cutouts 17. Alternatively, the support leads 18 can be entirely positioned in the cutouts 17. The lead terminals 13 are not necessarily partially arranged inside of the cutouts 17 of the stage 11. Alternatively, the lead terminals 13 can be entirely arranged inside of the cutouts 17 of the stage 11.

The lead frame 33 is processed by way of half-etching. Instead, the lead frame 33 can be processed by way of press working when the mold sheet 3 is not necessarily reduced in thickness, and when the semiconductor device 1 can be designed without consideration of resin burrs. That is, the lead terminals 13 can be subjected to bending. In this case, it is possible to form other recesses (similar to the recesses 24) which are positioned below the surface 3a of the stage 11.

The sound hole 9b allowing the cavity S 1 to communicate with the external space is not necessarily formed in the cover 9. Alternatively, the sound hole 9b can be formed at a prescribed position of the mold sheet 3.

The lead terminals 13 and the ground terminal 21 are not necessarily exposed on the backside 15b of the resin mold 15. The present embodiment simply requires that they are exposed externally of the mold sheet 3 so as to establish electric connection with the substrate (for mounting the semiconductor device 1). Alternatively, they can be exposed externally of the side surface 4 of the mold sheet 3. In this case, the ground terminal 21 can be formed using the interconnection lead 19.

The semiconductor device 1 does not necessarily include the companion chip 7 mounted on the surface 3 a of the stage 11. The present embodiment simply requires that the semiconductor device 1 includes at least the microphone chip 5. In this case, it is necessary to individually mount the companion chip 7 on the substrate (for mounting the semiconductor device 1), wherein the semiconductor device 1 is electrically connected to the companion chip 7 via the substrate.

The present embodiment describes the semiconductor chip 1 that has the microphone chip 5 for detecting pressure variations; but this is not a restriction. The present embodiment can be applied to any type of the semiconductor device having a sensor chip incorporated in the hollow cavity S1 defined between the mold sheet 3 and the cover 9. In other words, it can be applied to any type of the semiconductor device in which the sound hole 9b is not formed in the mold sheet 3 and the cover 9. It is possible to list various types of sensor chips such as acceleration sensor chips arranged inside of the cavity S1 that is air-tightly closed and isolated from the external space.

Lastly, the present invention is not necessarily limited to the present embodiment and variations thereof, which can be further modified in a variety of ways within the scope of the invention as defined by the appended claims.

## Claims

1. A semiconductor device comprising:
a sensor chip;
a mold sheet having a rectangular shape in a plan view and including a stage having a conductive property, in which a plurality of cutouts is formed in a periphery thereof, a plurality of lead terminals each having a conductive property which is arranged inside of the plurality of cutouts and is electrically connected to the sensor chip, and a resin mold having an insulating property which is formed to electrically insulate the stage from the plurality of lead terminals; and
a cover having an opening and a box-like shape, which is combined with the mold sheet so as to form a cavity therebetween,
wherein the sensor chip is mounted on a surface of the stage which forms a single plane as a surface of the mold sheet,
wherein the plurality of lead terminals includes a plurality of connection portions having internal connection surfaces, which are exposed in the cavity and are electrically connected to the sensor chip, and a plurality of support leads which are elongated from the plurality of connection portions towards the stage so that distal ends thereof are exposed on a side surface of the mold sheet,
wherein the plurality of support leads has a plurality of recesses which are recessed in width directions thereof and which is sealed with the mold resin, and
wherein an opening end of the cover is fixed onto the mold sheet above the recesses of the support leads sealed with the resin mold.

2. A semiconductor device according to claim 1, wherein the stage and the lead terminals are integrally formed using a lead frame that is produced using a thin metal plate, wherein the recesses are formed by partially etching a surface of the thin metal plate substantially corresponding to the surface of the stage, wherein the stage is formed by partially etching a backside of the thin metal plate and is thus reduced in thickness so that the lower side of the stage is sealed with the resin mold.

3. A semiconductor device according to claim 2, wherein the connection portions are formed by partially etching the backside of the thin metal plate and are thus reduced in thickness so that the lower sides of the connection portions are sealed with the resin mold.

4. A semiconductor device according to claim 1, wherein the mold sheet is integrally formed with the stage such that the mold sheet partially projects from the lower side of the stage so as to form a ground terminal, which is electrically connected to the sensor chip, and wherein an external connection surface of the ground terminal is exposed externally of the resin mold that is formed to seal the lower side of the stage.

5. A semiconductor device according to claim 1, wherein the sensor chip is a microphone chip having a sound detector for detecting pressure variations, and
wherein a sound hole is formed to run through the cover so as to allow the cavity to communicate with an external space.

6. A lead frame, which is produced using a thin metal plate, comprising:
a stage having a rectangular shape in a plan view for mounting a sensor chip thereon;
a plurality of lead terminals which are electrically connected to the sensor chip and which have a plurality of connection portions integrally connected with the stage;
a plurality of cutouts which are formed in a periphery of the stage so as to arrange the plurality of lead terminals and the plurality of connection portions therein; and
a plurality of support leads which are externally elongated from the plurality of connection portions, wherein a plurality of recesses is formed in the plurality of support leads inside of the plurality of cutouts.

7. A lead frame according to claim 6, wherein the plurality of recesses is formed by partially etching a surface of the thin metal plate which forms a same plane as a surface of the stage, and wherein the stage is formed by partially etching a backside of the thin metal plate and is thus reduced in thickness.

8. A microphone package
a microphone chip;
a mold sheet having a rectangular shape in a plan view and including a stage having a conductive property, in which a plurality of cutouts is formed in a periphery thereof, a plurality of lead terminals each having a conductive property which is arranged inside of the plurality of cutouts and is electrically connected to the microphone chip, and a resin mold having an insulating property which is formed to electrically insulate the stage from the plurality of lead terminals; and
a cover having a box-like shape, which is combined with the mold sheet so as to form a housing including a cavity and a sound hole,
wherein the plurality of lead terminals is arranged inside of the plurality of cutouts and is thus electrically insulated from the stage via the resin mold,
wherein the plurality of lead terminals includes a ground terminal formed integrally with the stage and a plurality of internal connection surfaces electrically connected to the microphone chip,
wherein the stage and the plurality of lead terminals are sealed with the resin mold such that the surface of the stage and the plurality of internal connection surfaces are exposed from the mold sheet in the housing, and
wherein the cover is electrically insulated from the plurality of lead terminals and is electrically connected to the stage.

9. A microphone package according 8, wherein the mold sheet includes a lead frame, which is formed using a thin metal plate and which includes the stage, the plurality of lead terminals, and a plurality of support leads which are elongated from the plurality of lead terminals so that distal ends thereof are exposed on a side surface of the mold sheet, and wherein a plurality of recesses is formed in the plurality of support leads and is sealed with the resin mold.

10. A microphone package according to claim 9, wherein a plurality of interconnection leads is extended from a periphery of the stage so that distal ends thereof are exposed on the side surface of the mold sheet, and wherein the plurality of interconnection leads come in contact with the cover when the cover is mounted and fixed onto the mold sheet.

11. A microphone package according to claim 8, wherein the mold sheet includes a lead frame having a frame, which is formed using a thin metal plate, wherein the plurality of lead terminals has a plurality of support leads which are extended therefrom so as to join the frame, wherein a plurality of recesses is formed by performing half-etching on the plurality of support leads, wherein a plurality of interconnection leads is extended from a periphery of the stage so that distal ends thereof are exposed on a side surface of the mold sheet, wherein the lead frame of the mold sheet is sealed with a resin such that the plurality of recesses is sealed with the resin mold, and wherein the mold sheet is subjected to cutting so as to cut out the plurality of interconnection leads.
